(19) Europäisches Patentamt
European Patent Office
Office européen des brevets

(11) **EP 2 412 022 B1**

(12) **EUROPÄISCHE PATENTSCHRIFT**

(45) Veröffentlichungstag und Bekanntmachung des Hinweises auf die Patenterteilung:
**21.11.2018 Patentblatt 2018/47**

(21) Anmeldenummer: **10706229.1**

(22) Anmeldetag: **01.03.2010**

(51) Int Cl.:
*H01L 25/13* ^(2006.01)    *H01L 33/00* ^(2010.01)

(86) Internationale Anmeldenummer:
**PCT/EP2010/052564**

(87) Internationale Veröffentlichungsnummer:
**WO 2010/108761 (30.09.2010 Gazette 2010/39)**

(54) **OPTOELEKTRONISCHES HALBLEITERBAUTEIL UND ANZEIGEEINRICHTUNG**

OPTOELECTRONIC SEMICONDUCTOR DEVICE AND DISPLAY

DISPOSITIF SEMI-CONDUCTEUR OPTOÉLECTRONIQUE ET AFFICHEUR

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **27.03.2009 DE 102009015313**

(43) Veröffentlichungstag der Anmeldung:
**01.02.2012 Patentblatt 2012/05**

(73) Patentinhaber: **OSRAM Opto Semiconductors GmbH**
**93055 Regensburg (DE)**

(72) Erfinder:
• **BRICK, Peter**
**93051 Regensburg (DE)**
• **WITTMANN, Michael**
**93087 Alteglofsheim (DE)**
• **WEBER-RABSILBER, Sven**
**93073 Neutraubling (DE)**

(74) Vertreter: **Epping - Hermann - Fischer Patentanwaltsgesellschaft mbH Schloßschmidstraße 5 80639 München (DE)**

(56) Entgegenhaltungen:
EP-A2- 1 641 052    DE-A1-102006 047 233
US-A1- 2007 206 390    US-A1- 2007 273 984
US-B1- 6 523 976

**Beschreibung**

Es wird ein optoelektronisches Halbleiterbauteil angegeben. Darüber hinaus wird eine Anzeigeeinrichtung mit einem solchen optoelektronischen Halbleiterbauteil angegeben.

Die Druckschrift DE 10 2004 057 499 A1 betrifft eine Vorrichtung zur Lichterzeugung.

In der Druckschrift DE 10 2006 047 233 A1 ist ein optisches Element für eine Leuchtdiode angegeben.

Ein Projektionssystem mit einer Licht emittierenden Diode findet sich in der Druckschrift US 2007/0206390 A1.

Es offenbart die Druckschrift EP 1 641 052 A2 ein Licht emittierendes Bauteil mit einer Linse.

In der Druckschrift US 2007/0273984 A1 ist eine Lichtleiterlinse beschrieben.

Eine Linsenanordnung ist in der Druckschrift US 6,523,976 B1 wiedergegeben.

Eine zu lösende Aufgabe besteht darin, ein optoelektronisches Halbleiterbauteil anzugeben, das über einen großen Winkelbereich eine bezüglich eines Farborts eine homogene Abstrahlcharakteristik aufweist. Weiterhin besteht eine zu lösende Aufgabe darin, eine Anzeigeeinrichtung mit einem solchen optoelektronischen Halbleiterbauteil anzugeben.

Diese Aufgabe wird gelöst durch ein optoelektronisches Halbleiterbauteil mit den Merkmalen des Anspruchs 1.

Das erfindungsgemäße optoelektronische Halbleiterbauteil umfasst mindestens zwei optoelektronische Halbleiterchips. Beispielsweise sind die Halbleiterchips als Leuchtdioden, kurz LEDs, als Laserdioden oder als Superlumineszenzdioden ausgestaltet. Bevorzugt umfasst das optoelektronische Halbleiterbauteil genau drei oder genau vier optoelektronische Halbleiterchips.

Gemäß zumindest einer Ausführungsform des optoelektronischen Halbleiterbauteils sind die mindestens zwei optoelektronischen Halbleiterchips dazu eingerichtet, im Betrieb in voneinander verschiedenen Wellenlängenbereichen eine elektromagnetische Strahlung zu emittieren. Die optoelektronischen Halbleiterchips können hierbei unterschiedlich gestaltet sein, so dass in aktiven Schichten der Halbleiterchips Strahlung mit unterschiedlichen Wellenlängen erzeugt wird. Alternativ oder zusätzlich ist es möglich, dass die optoelektronischen Halbleiterchips jeweils eine Primärstrahlung mit einer gleichen Wellenlänge emittieren und dass zumindest einem der Halbleiterchips ein Konversionsmittel nachgeordnet ist, das die von diesem Halbleiterchip emittierte Strahlung mindestens teilweise in eine Strahlung einer anderen Wellenlänge umwandelt.

Gemäß zumindest einer Ausführungsform des optoelektronischen Halbleiterbauteils beinhaltet dieses einen Träger mit einer Montagefläche. Der Träger ist beispielsweise mit einem Kunststoffmaterial gestaltet und umfasst Anschlusseinrichtungen zur elektrischen Kontaktierung der Halbleiterchips. Weiterhin stellt der Träger eine das Halbleiterbauteil mechanisch tragende Einheit dar.

Gemäß zumindest einer Ausführungsform des optoelektronischen Halbleiterbauteils sind die Halbleiterchips auf der Montagefläche des Trägers angebracht. Der Träger ist dann ein gemeinsamer Träger für alle Halbleiterchips.

Gemäß zumindest einer Ausführungsform des optoelektronischen Halbleiterbauteils umfasst dieses mindestens zwei Linsenkörper. An zumindest einer Grenzfläche des Linsenkörpers, insbesondere an einer den Halbleiterchips abgewandten Grenzfläche, erfolgt eine Brechung der von den Halbleiterchips emittierten Strahlung. Die Linsenkörper sind nicht rotationssymmetrisch geformt. Mit anderen Worten weisen die Linsenkörper bevorzugt höchstens zwei Symmetrieebenen auf, bezüglich derer die Linsenkörper spiegelsymmetrisch geformt sind.

Gemäß zumindest einer Ausführungsform des optoelektronischen Halbleiterbauteils sind die Linsenkörper dazu eingerichtet, entlang zweier zueinander orthogonalen Richtungen parallel zur Montagefläche die Strahlung in voneinander verschiedene Abstrahlwinkel zu formen. Mit anderen Worten erfolgt durch die Linsenkörper entlang der zwei zueinander orthogonalen Richtungen eine unterschiedliche Strahlaufweitung oder Strahlbündelung. Parallel zur Montagefläche kann hierbei bedeuten, dass durch die zwei zueinander orthogonalen Richtungen eine Ebene aufgespannt ist, die senkrecht zu einer Hauptabstrahlrichtung des Halbleiterbauteils orientiert ist und/oder die eine Tangentenebene zur Montagefläche darstellt. Parallel zur Montagefläche impliziert also nicht notwendigerweise, dass die Montagefläche eben geformt ist.

Gemäß zumindest einer Ausführungsform des optoelektronischen Halbleiterbauteils ist jedem der Halbleiterchips einer der Linsenkörper in einer Abstrahlrichtung nachgeordnet. Insbesondere ist jedem der Halbleiterchips genau einer der Linsenkörper eindeutig zugeordnet. Die Abstrahlrichtung ist insbesondere diejenige Richtung, in der die vom Halbleiterbauteil abgestrahlte Leistung ein Maximum aufzeigt. Bevorzugt ist die Abstrahlrichtung senkrecht zu den beiden zueinander orthogonalen Richtungen orientiert.

In mindestens einer Ausführungsform des optoelektronischen Halbleiterbauteils umfasst dieses zumindest zwei optoelektronische Halbleiterchips, die dazu eingerichtet sind, im Betrieb in voneinander verschiedenen Wellenlängenbereichen eine elektromagnetische Strahlung zu emittieren. Die Halbleiterchips sind auf einer Montagefläche eines gemeinsamen Trägers angebracht. Weiterhin beinhaltet das optoelektronische Halbleiterbauteil mindestens zwei nicht rotationssymmetrisch gestaltete Linsenkörper, die dazu eingerichtet sind, entlang zweier zueinander orthogonalen Richtungen parallel zur Montagefläche die Strahlung in voneinander verschiedene Abstrahlwinkel zu formen. Jedem der Halbleiterchips ist hierbei einer der Linsenkörper in einer Abstrahlrichtung nachgeordnet oder zugeordnet.

Jedem der bevorzugt in unterschiedlichen Farben emittierenden Halbleiterchips ist also eine eigene Linse in Abstrahlrichtung nachgeordnet. Dadurch, dass somit jede Farbe über einen eigenen Linsenkörper bezüglich ihrer Abstrahlcharakteristik geformt wird und dadurch, dass die Linsenkörper nicht rotationssymmetrisch geformt sind, kann eine hohe Farbhomogenität einer vom optoelektronischen Halbleiterbauteil emittierten Gesamtstrahlung über einen weiten Betrachtungswinkel erreicht werden. Auch können die Abstrahlcharakteristiken in einer horizontalen und in einer vertikalen Richtung unterschiedlich eingestellt sein. Hierdurch kann das Halbleiterbauteil in Anzeigeeinrichtungen oder Displays eingesetzt werden, bei denen unterschiedliche Abstrahlwinkel in vertikaler und horizontaler Richtung erwünscht sind.

Das optoelektronische Halbleiterbauteil kann als so genannte RGB-Einheit gestaltet werden. Mit anderen Worten emittiert einer der Halbleiterchips im roten Spektralbereich, mindestens einer der Halbleiterchips im grünen Spektralbereich und ein weiterer Halbleiterchip im blauen Spektralbereich. Halbleiterchips, die in einer gleichen Farbe Strahlung emittieren, stellen bevorzugt einen Farbkanal dar. Weiterhin ist bevorzugt jeder der Halbleiterchips und/oder jeder der Farbkanäle einzeln elektronisch ansteuerbar. Über die Ansteuerbarkeit der Farbkanäle ist also ein Farbort einer vom Halbleiterbauteil zu emittierenden Gesamtstrahlung insbesondere zeitlich veränderlich einstellbar.

Gemäß zumindest einer Ausführungsform des optoelektronischen Halbleiterbauteils ist der Farbort der vom Halbleiterbauteil emittierten Gesamtstrahlung in einem optischen Fernfeld, abhängig von einem Betrachtungswinkel, über einen Winkelbereich von mindestens 30° um höchstens 0,02 Einheiten der CIELUV-Normfarbtafel variiert, bevorzugt um höchstens 0,005 Einheiten. Mit anderen Worten erscheint die Farbe der Gesamtstrahlung über den Winkelbereich von mindestens 30°, bezogen auf den Betrachtungswinkel, dem menschlichen Auge homogen und/oder gleich bleibend.

In einem optischen Fernfeld bedeutet hierbei, dass der Farbort in einem im Vergleich zu lateralen Abmessungen des Halbleiterbauteils oder der Linsenkörper großen Abstand gemessen wird. Großer Abstand kann hierbei bedeuten, dass der Abstand mindestens ein Zehnfaches, bevorzugt mindestens ein Hundertfaches einer lateralen Abmessung des Halbleiterbauteils oder der Linsenkörper entspricht. Erstrecken sich die Linsenkörper des Halbleiterbauteils längs der Montagefläche beispielsweise über eine Strecke von 3 mm, so wird der Farbort bevorzugt in einem Abstand von mindestens 300 mm bestimmt.

Dass der Farbort um höchstens 0,02 Einheiten, bevorzugt um höchstens 0,005 Einheiten sich über den Winkelbereich ändert, kann bedeuten, dass sich alle Farborte in dem Winkelbereich in einer Region der CIELUV-Normfarbtafel befinden, die durch einen Kreis mit einem Radius von 0,02 Einheiten definiert ist. Mit anderen Worten beträgt ein Abstand in der CIELUV-Normfarbtafel zwischen zwei Farborten der Strahlung in dem Winkelbereich höchstens 0,04 Einheiten.

Gemäß zumindest einer Ausführungsform des optoelektronischen Halbleiterbauteils ändert sich der Farbort der vom Halbleiterbauteil emittierten Gesamtstrahlung, abhängig von dem Betrachtungswinkel, entlang einer ersten, insbesondere horizontalen Richtung der zwei zueinander orthogonalen Richtungen innerhalb eines Winkelbereichs von 110° um weniger als 0,04 Einheiten der Normfarbtafel, insbesondere um weniger als 0,01 Einheiten. Als Referenz für den Farbort dient hierbei bevorzugt jeweils der Farbort der Strahlung, die in der Abstrahlrichtung, also insbesondere in einer Richtung senkrecht zu dem Träger, von dem Halbleiterbauteil emittiert wird. Mit anderen Worten ist eine Farbortabweichung der Strahlung über den angegebenen Winkelbereich hinweg, bezogen auf den Farbort der Strahlung entlang der Abstrahlrichtung, kleiner als 0,02 Einheiten, insbesondere kleiner als 0,005 Einheiten.

Gemäß zumindest einer Ausführungsform des optoelektronischen Halbleiterbauteils ändert sich der Farbort entlang einer zweiten, insbesondere vertikalen Richtung der zwei zueinander orthogonalen Richtungen innerhalb eines Winkelbereichs von 40° um weniger als 0,04 Einheiten der Normfarbtafel, bevorzugt um weniger als 0,01 Einheiten. Die Farbortänderung ist bevorzugt jeweils auf den Farbort der Strahlung entlang der Abstrahlrichtung bezogen. Mit anderen Worten ist eine Farbortabweichung der Strahlung über den angegebenen Winkelbereich hinweg, bezogen auf den Farbort der Strahlung entlang der Abstrahlrichtung, kleiner als 0,02 Einheiten, insbesondere kleiner als 0,005 Einheiten.

Gemäß zumindest einer Ausführungsform des optoelektronischen Halbleiterbauteils liegt ein Aspektverhältnis der Linsenkörper bezüglich der zueinander orthogonalen Richtungen zwischen einschließlich 0,3 und 0,9. Bevorzugt liegt das Aspektverhältnis im Bereich zwischen einschließlich 0,35 und 0,6. Das Aspektverhältnis ist hierbei der Quotient aus der maximalen Ausdehnung des Linsenkörpers entlang der zweiten Richtung und der maximalen Ausdehnung des Linsenkörpers entlang der ersten Richtung. Die zweite Richtung ist hierbei insbesondere diejenige der zwei zueinander orthogonalen Richtungen, in der der Abstrahlwinkel kleiner ist als bezüglich der ersten Richtung. Bevorzugt liegt ein Aspektverhältnis einer winkelabhängigen Intensitätsverteilung in entsprechenden Wertebereichen.

Gemäß zumindest einer Ausführungsform des optoelektronischen Halbleiterbauteils betragen die maximalen Ausdehnungen des Linsenkörpers entlang der zueinander orthogonalen Richtungen höchstens das Neunfache von maximalen Abmessungen des Halbleiterchips entlang der entsprechenden Richtungen. Bevorzugt betragen die maximalen Ausdehnungen des Linsenkörpers höchstens das Achtfache, insbesondere höchstens das Siebenfache der zugehörigen maximalen Abmessungen des Halbleiterchips. Weist der Halbleiterchip beispielsweise entlang der ersten Richtung eine Länge von 300 µm auf, so beträgt die maximale Ausdehnung des Linsenkörpers entlang der ersten Richtung höchstens 2,7 mm, bevorzugt höchstens 2,4 mm, insbesondere höchstens 2,1 mm.

Gemäß zumindest einer Ausführungsform des optoelektronischen Halbleiterbauteils beträgt eine Höhe des Linsenkörpers, insbesondere in einer Richtung parallel zur Abstrahlrichtung, zwischen dem einschließlich 0,25-fachen und 0,95-fachen der maximalen Ausdehnung des Linsenkörpers entlang der zwei zueinander orthogonalen Richtungen. Bevorzugt liegt die Höhe zwischen dem einschließlich 0,5-fachen und 0,8-fachen der maximalen Ausdehnung des Linsenkörpers. Beträgt beispielsweise die maximale Ausdehnung des Linsenkörpers entlang der ersten Richtung 1 mm, so liegt die Höhe des Linsenkörpers bevorzugt zwischen einschließlich 0,25 mm und 0,95 mm, insbesondere zwischen einschließlich 0,5 mm und 0,8 mm.

Gemäß zumindest einer Ausführungsform des optoelektronischen Halbleiterbauteils sind benachbarte Linsenkörper bezüglich der von den Halbleiterchips emittierten Strahlung optisch voneinander isoliert. Mit anderen Worten gelangt kein signifikanter Strahlungsanteil oder kein Strahlungsanteil, der von einem der Halbleiterchips erzeugt wird, in einen der Linsenkörper, der nicht diesem Halbleiterchip zugeordnet ist. Nicht signifikant bedeutet beispielsweise, dass weniger als 5 %, insbesondere weniger als 1 % der Strahlungsleistung eines der Halbleiterchips in benachbarte Linsenkörper gelangt.

Im optoelektronischen Halbleiterbauteil kann die optische Isolierung zwischen benachbarter Linsenkörper durch eine Beschichtung auf einem Vergusskörper und/oder zumindest einem der Linsenkörper realisiert sein. Alternativ oder zusätzlich kann die optische Isolierung durch eine Strahlfalle, die auf dem Träger angebracht oder in den Vergusskörper und/oder in mindestens einen der Linsenkörper integriert ist, verwirklicht sein.

Im optoelektronischen Halbleiterbauteil kann ein Abstand zwischen benachbarten Linsenkörpern mindestens 75 $\mu$m, insbesondere mindestens 100 $\mu$m betragen. Bevorzugt beträgt der Abstand zwischen den benachbarten Linsenkörpern mindestens 5 %, bevorzugt mindestens 10 % der Höhe des Linsenkörpers insbesondere entlang der Abstrahlrichtung. Alternativ oder zusätzlich beträgt der Abstand mindestens 4 %, insbesondere mindestens 8 % einer maximalen Ausdehnung des Linsenkörpers entlang einer der zwei zueinander orthogonalen Richtungen.

Gemäß zumindest einer Ausführungsform des optoelektronischen Halbleiterbauteils beträgt ein Lichteinsammelwinkel der Linsenkörper bezüglich der von dem zugeordneten Halbleiterchip emittierten Strahlung entlang der ersten Richtung mindestens 145°, bevorzugt mindestens 160°, und entlang der vertikalen Richtung mindestens 130°, bevorzugt mindestens 145°. Durch solche Lichteinsammelwinkel ist es ermöglicht, dass mindestens 80 %, bevorzugt mindestens 90 % der vom Halbleiterchip emittierten Strahlungsleistung in den zugeordneten Linsenkörper gelangen.

Gemäß zumindest einer Ausführungsform des optoelektronischen Halbleiterbauteils sind die Linsenkörper jeweils unterschiedlich ausgeformt. Mit anderen Worten umfasst das optoelektronische Halbleiterbauteil keine zwei Linsenkörper, die im Rahmen der Herstellungstoleranzen eine gleiche Geometrie aufweisen.

Im optoelektronischen Halbleiterbauteil können mindestens zwei der Linsenkörper des optoelektronischen Halbleiterbauteils höchstens eine, insbesondere genau eine Symmetrieebene aufweisen. Die Symmetrieebene ist hierbei bevorzugt eine Spiegelsymmetrieebene.

Im optoelektronischen Halbleiterbauteil können die Linsenkörper, in Draufsicht auf die Montagefläche des Trägers, in einer dreieckigen oder viereckigen Anordnung angeordnet sein. Bevorzugt liegen die Linsenkörper in einer Anordnung, entsprechend einem gleichseitigen Dreieck, oder in einer quadratischen Anordnung vor. Mit anderen Worten sind die Linsenkörper und bevorzugt dann auch die Halbleiterbauteile an den Eckpunkten eines solchen Dreiecks oder Vierecks angeordnet. Ebenso ist es möglich, dass zusätzlich ein weiterer Halbleiterchip sowie der zugehörige Linsenkörper zentral, also insbesondere im Flächenschwerpunkt des von den anderen Halbleiterchips aufgespannten Dreiecks oder Vierecks, angeordnet ist.

Gemäß zumindest einer Ausführungsform des optoelektronischen Halbleiterbauteils befindet sich zwischen den Linsenkörpern und den Halbleiterchips ein Vergusskörper. Weiterhin bevorzugt befinden sich die Linsenkörper in mindestens mittelbarem Kontakt mit dem Vergusskörper und sind dem Vergusskörper in Abstrahlrichtung nachgeordnet. Insbesondere umgibt der Vergusskörper die Halbleiterchips, mit Ausnahme von dem Träger zugewandten Seiten der Halbleiterchips, vollständig. Mit anderen Worten sind die Halbleiterchips von dem Träger und dem Vergusskörper dann vollständig eingeschlossen.

Im optoelektronischen Halbleiterbauteil können die Linsenkörper auf dem Vergusskörper aufgeklebt, aufgegossen oder aufgeschmolzen sein. Die Linsenkörper und der Vergusskörper werden also beispielsweise unterschiedlich und unabhängig voneinander hergestellt und erst nachträglich zusammengefügt.

Gemäß zumindest einer Ausführungsform des optoelektronischen Halbleiterbauteils sind alle Linsenkörper oder, sofern ein Vergusskörper vorhanden ist, alle Linsenkörper und der Vergusskörper einstückig gestaltet und bestehen aus demselben Material. Beispielsweise ist der Vergusskörper und alle Linsenkörper durch ein Gießen, durch ein Pressen oder durch ein Formpressen im selben Verfahrensschritt erzeugt.

Im optoelektronischen Halbleiterbauteil können der Vergusskörper und die Linsenkörper ein Silikon, ein Epoxid oder ein Silikon-Epoxid-Hybrid-Material umfassen oder bestehen hieraus.

Gemäß zumindest einer Ausführungsform des optoelektronischen Halbleiterbauteils umfasst dieses mindestens eine Abschirmung gegen Fremdstrahlung. Fremdstrahlung ist hierbei eine solche Strahlung, die nicht vom optoelektronischen Halbleiterbauteil selbst erzeugt ist. Beispielsweise ist die Fremdstrahlung durch Sonnenlicht gegeben. Die Abschirmung verhindert also insbesondere, dass direkt eingestrahltes Sonnenlicht etwa auf die Halbleiterchips oder auf ein Konversionsmittel trifft.

Gemäß zumindest einer Ausführungsform des optoelektronischen Halbleiterbauteils folgt eine Oberflächenform mindestens eines oder aller der Linsenkörper, innerhalb einer Abweichung eines z-Wertes von höchstens 10 % einer Höhe T des jeweiligen Linsenkörpers, folgender Gleichung:

$$z(x, y) = -0,33866\ x^2 - 0,93234\ y^2 - 0,54136\ x^4 - 1,25032\ x^2\ y^2 + 1,78606\ y^4 + 0,50057\ x^6 + 1,27170\ x^4\ y^2 + 0,06042\ x^2\ y^4 - 4,44960\ y^6 - 0,10344\ x^8 + 1,56205\ x^6\ y^2 + 6,38833\ x^4\ y^4 + 2,05268\ x^2\ y^6 - 18,7818\ y^8 - 0,158501\ x^{10} - 2,955774\ x^8\ y^2 - 10,73336\ x^6\ y^4 - 26,66134\ x^4\ y^6 - 2,344646\ x^2\ y^8 + 0,127770\ y^{10}.$$

Mit anderen Worten ist die Oberflächenform, also eine dem Träger abgewandte Begrenzungsfläche des Linsenkörpers, näherungsweise durch die angegebene Gleichung beschreibbar. Näherungsweise kann hierbei bedeuten, dass tatsächliche z'-Werte der Oberflächenform des Linsenkörpers, für jeweils ein gegebenes x und y, innerhalb eines Intervalls von z - 0,1 T bis z + 0,1 T liegen, bevorzugt innerhalb eines Intervalls von z - 0,05 T bis z + 0,05 T, wobei die Intervallgrenzen jeweils eingeschlossen sind. Die tatsächlichen z'-Werte weichen von den z-Werten aus der angegebenen Gleichung also um höchsten 10 % der Höhe T des Linsenkörpers, bevorzugt um höchstens 5 % der Höhe T, ab. Die Höhe T ist dabei die maximale Höhe des Linsenkörpers. Über eine Wahl einer Einheitslänge für die Koordinaten x und y kann eine Skalierung des Linsenkörpers erfolgen. Bevorzugt sind die Einheitslängen für die Koordinaten x und y gleich groß, zum Beispiel jeweils 1 mm.

Gemäß zumindest einer Ausführungsform des optoelektronischen Halbleiterbauteils beträgt ein Abstand zwischen zwei benachbarten Linsenkörpern mindestens 10 % oder mindestens 156 % einer maximalen Ausdehnung von einem der benachbarten Linsenkörpers in derselben Richtung.

Darüber hinaus wird eine Anzeigeeinrichtung angegeben. Die Anzeigeeinrichtung umfasst einen erfindungsgemäßen optoelektronischen Halbleiterbauteil.

Merkmale des optoelektronischen Halbleiterbauteils sind daher auch für die hier beschriebene Anzeigeeinrichtung offenbart und umgekehrt.

Gemäß zumindest einer Ausführungsform der Anzeigeeinrichtung umfasst diese eine Vielzahl von Bildpunkten. Die Anzeigeeinrichtung stellt beispielsweise ein Display dar.

Gemäß zumindest einer Ausführungsform der Anzeigeeinrichtung ist jeder der Bildpunkte durch ein optoelektronisches Halbleiterbauteil gemäß einer der vorhergehenden Ausführungsformen gebildet.

Gemäß zumindest einer Ausführungsform der Anzeigeeinrichtung beträgt ein Abstand zwischen benachbarten Bildpunkten zwischen einschließlich 4 mm und 75 mm, bevorzugt zwischen einschließlich 8 mm und 50 mm, insbesondere zwischen einschließlich 12 mm und 23 mm.

In der Anzeigeeinrichtung können die Bildpunkte matrixartig in Zeilen und Spalten angeordnet sein. Weiterhin ist bevorzugt jeder der Bildpunkte einzeln ansteuerbar.

Die Anzeigeeinrichtung kann frei von einer Maske sein. Eine Maske ist hierbei insbesondere eine Vorrichtung, die dazu eingerichtet ist, zeitlich abhängig eine Farbfilterung der in den Bildpunkten erzeugten Strahlung zu realisieren. Insbesondere ist die Anzeigeeinrichtung frei von einer Flüssigkristallmaske, kurz LCD-Maske.

Nachfolgend wird ein hier beschriebenes optoelektronisches Halbleiterbauteil sowie eine hier beschriebene Anzeigeeinrichtung unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figur 1        eine schematische Darstellung eines Ausführungsbeispiels eines hier beschriebenen optoelektronischen Halbleiterbauteils,

Figur 2        eine schematische Darstellung einer winkelabhängigen Intensitätsverteilung (A) und einer winkelabhängigen Farbortverteilung (B) eines Ausführungsbeispiels eines hier beschriebenen Halbleiterbauteils,

Figuren 3 bis 8    schematische Darstellungen von weiteren Ausführungsbeispielen von hier beschriebenen Halbleiterbauteilen, und

Figur 9    eine schematische Darstellung eines Ausführungsbeispiels einer hier beschriebenen Anzeigeeinrichtung.

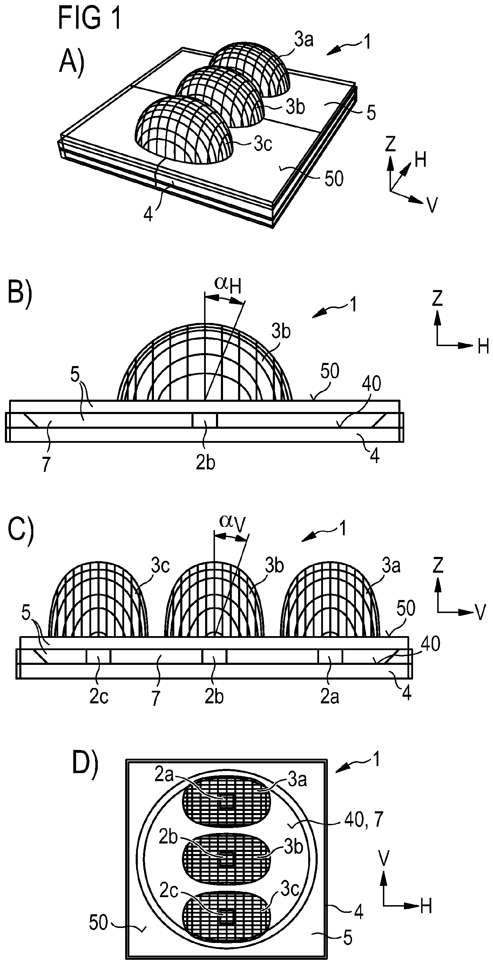

In Figur 1 ist ein Ausführungsbeispiel eines optoelektronischen Halbleiterbauteils 1 dargestellt, vergleiche die dreidimensionale Darstellung in Figur 1A, die Vorderansicht in Figur 1B, die Seitenansicht in Figur 1C und die Draufsicht in Figur 1D. Das Halbleiterbauteil 1 umfasst einen Träger 4 mit einer Montagefläche 40. Auf der Montagefläche 40 sind drei Halbleiterchips 2a-c aufgebracht. Eine elektrische Kontaktierung der Halbleiterchips 2a-c erfolgt über in Figur 1 nicht dargestellte elektrische Anschlusseinrichtungen des Trägers 4. Jeder der Halbleiterchips 2a-c emittiert in einem unterschiedlichen Spektralbereich. Beispielsweise emittiert der Halbleiterchip 2a rotes Licht, der Halbleiterchip 2b grünes Licht und der Halbleiterchip 2c blaues Licht. Weiterhin sind die Halbleiterchips 2a-c separat elektrisch ansteuerbar, so dass ein Farbort der vom Halbleiterbauteil 1 erzeugten Strahlung einstellbar ist.

Eine Ausnehmung 7 des Trägers 4, in dem sich die Halbleiterchips 2a-c und die Montagefläche 7 befinden, ist von einem Vergusskörper 5 ausgefüllt und überdeckt. Der Vergusskörper 5 umgibt, zusammen mit dem Träger 4, die Halbleiterchips 2a-c vollständig. Anders als in Figur 1 dargestellt, kann das Halbleiterbauteil 1 auch frei von einem Vergusskörper sein. In diesem Fall sind die Halbleiterchips 2a-c bevorzugt von Linsenkörpern 3a-c und dem Träger 4 vollständig umhüllt. Der Vergusskörper 5 stellt eine Art Podest für die Linsenkörper 3a-c dar.

Die Ausnehmung 7 des Trägers 4 kann mit mindestens einer reflektierenden, absorbierenden oder farbigen Schicht versehen sein. Über diese Schicht an der Ausnehmung 7 oder auch am gesamten Träger 4 oder nur an der Montagefläche 40 ist ein Erscheinungsbild und/oder sind optische Eigenschaften des Halbleiterbauteils 1 gezielt einstellbar.

An einer dem Träger 4 abgewandten Oberseite 50 des Vergusskörpers 5 befinden sich die drei Linsenkörper 3a-c. Die Linsenkörper 3a-c und der Vergusskörper 5 sind einstückig ausgeführt und bestehen aus demselben Material, beispielsweise einem Silikon, einem Epoxid oder einem Silikon-Epoxid-Hybrid-Material. Jedem der Halbleiterchips 2a-c ist genau einer der Linsenkörper 3a-c eindeutig zugeordnet. Die Linsenkörper 3a-c weisen entlang einer horizontalen Richtung H und entlang einer vertikalen Richtung V unterschiedliche Abmessungen und Krümmungen auf. Durch die horizontale Richtung H und die vertikale Richtung V ist insbesondere eine Tangentenebene zur Montagefläche 40 aufgespannt, die bevorzugt senkrecht zu einer Abstrahlrichtung z orientiert ist. Die Abstrahlrichtung z ist insbesondere eine Hauptabstrahlrichtung des Halbleiterbauteils 1, in die eine maximale Strahlungsleistung emittiert wird.

Die Linsenkörper 3a-c sind insbesondere bezüglich der Abstrahlrichtung z nicht rotationssymmetrisch gestaltet. Eine Abstrahlcharakteristik entlang der horizontalen Richtung H ist hierdurch anders einstellbar als eine Abstrahlcharakteristik entlang der vertikalen Richtung V. Es folgt eine Oberflächenform der Linsenkörper 3a-c folgender Gleichung:

$$z\,(x,\,y) = -0{,}33866\ x^2 - 0{,}93234\ y^2 - 0{,}54136\ x^4 - 1{,}25032\ x^2\ y^2 + 1{,}78606\ y^4 + 0{,}50057\ x^6 + 1{,}27170\ x^4\ y^2 + 0{,}06042\ x^2\ y^4 - 4{,}44960\ y^6 - 0{,}10344\ x^8 + 1{,}56205\ x^6\ y^2 + 6{,}38833\ x^4\ y^4 + 2{,}05268\ x^2\ y^6 - 18{,}7818\ y^8 - 0{,}158501\ x^{10} - 2{,}955774\ x^8\ y^2 - 10{,}73336\ x^6\ y^4 - 26{,}66134\ x^4\ y^6 - 2{,}344646\ x^2\ y^8 + 0{,}127770\ y^{10}.$$

x, y und z sind hierbei einheitenlose Zahlen. Eine x-Achse ist parallel zur horizontalen Richtung H und eine y-Achse parallel zur vertikalen Richtung V orientiert. Die x-und die y-Achse, bezogen auf den jeweiligen Linsenkörper, schneiden sich in der xy-Ebene insbesondere an der Stelle, wo z für den jeweiligen Linsendkörper 3a-c maximal ist.

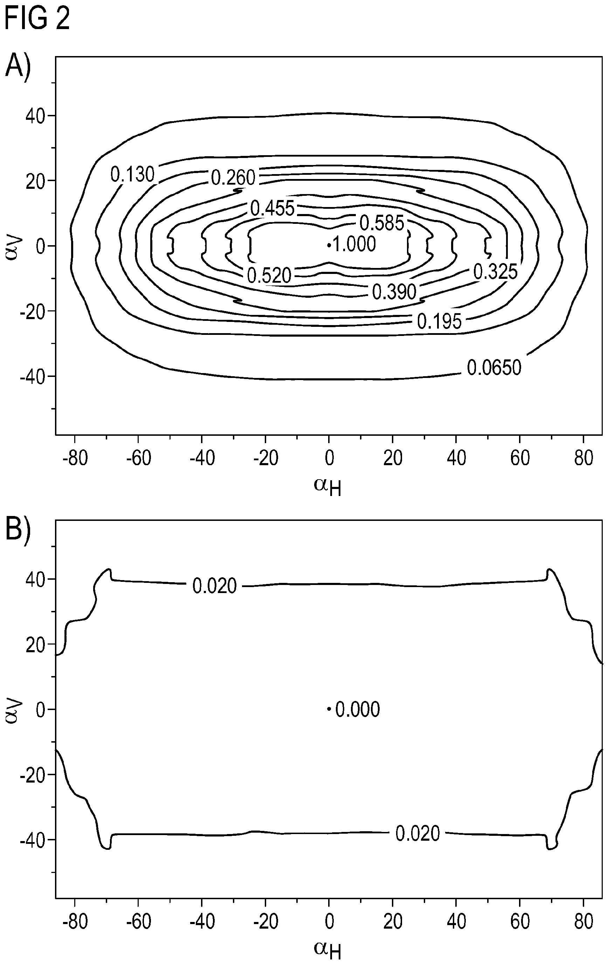

In Figur 2A ist in Form von Profillinien eine Intensitätsverteilung einer etwa vom optoelektronischen Halbleiterbauteil 1 gemäß Figur 1 emittierten Gesamtstrahlung in Abhängigkeit eines Abstrahlwinkels $\alpha_H$ entlang der horizontalen Richtung H und eines Abstrahlwinkels $\alpha_V$ entlang der vertikalen Richtung V illustriert.

Eine maximale Strahlungsleistung wird in die Abstrahlrichtung z emittiert, also für $\alpha_H = \alpha_V = 0$. Diese Strahlungsleistung entlang der Abstrahlrichtung z ist auf eins normiert. Gemäß Figur 2A wird die Gesamtstrahlung bezüglich der vertikalen Richtung V und der horizontalen Richtung H unterschiedlich emittiert. Entlang der vertikalen Richtung V wird in einen Winkelbereich von zirka -40° bis +40°, also über einen Winkelbereich von insgesamt zirka 80°, eine winkelabhängige Strahlungsleistung von mindestens 6 % der Strahlungsleistung entlang der Abstrahlrichtung z emittiert. Entlang der horizontalen Richtung H erfolgt dies für Winkel zwischen zirka -80° und +80°, also über einen Gesamtwinkelbereich von etwa 160°.

In Figur 2B ist eine entsprechende Darstellung bezüglich des Farborts der vom Halbleiterbauteil 1 emittierten Gesamtstrahlung im optischen Fernfeld gezeigt. Fernfeld bedeutet hierbei, dass der Abstand, in dem der Farbort winkelabhängig bestimmt wird, deutlich größer ist als laterale Abmessungen der Linsenkörper 2a-c. Innerhalb einer Umrisslinie beträgt die maximale Abweichung von dem Farbort der in den verschiedenen Winkeln emittierten Strahlung, bezogen auf die Strahlung entlang der Abstrahlrichtung oder der Hauptabstrahlrichtung, höchstens 0,020 Einheiten in der CIELUV-Normfarbtafel. Die Farbortabweichung gemäß Figur 2B ist also auf den Farbort der Strahlung für $\alpha_H = \alpha_V$ = 0 bezogen, für $\alpha_H = \alpha_V$ = 0 ist die Abweichung daher 0,000. Mit anderen Worten weisen alle Farborte der Gesamtstrahlung innerhalb der in Figur 2B gezeigten Umrisslinie also einen Abstand in der CIELUV-Normfarbtafel von höchstens 0,040 Einheiten zueinander auf. In dem umrissenen Winkelbereich erscheint die Strahlung also, unabhängig von einem Betrachtungswinkel, dem menschlichen Auge farblich gleich. Ein Farbort der Gesamtstrahlung des Halbleiterbauteils 1 ist mit anderen Worten in dem Winkelbereich innerhalb der Umrisslinie näherungsweise unabhängig vom Betrachtungswinkel.

Bezüglich des Abstrahlwinkels $\alpha_V$ entlang der vertikalen Richtung V ist der Farbort in einem Winkelbereich von zirka - 40° bis zirka +40°, also über einen Winkelbereich von etwa 80° hinweg, näherungsweise konstant. Entlang der horizontalen Richtung H bezüglich des Abstrahlwinkels $\alpha_H$ wird diese Homogenität über nahezu die gesamte Halbebene, also von näherungsweise -85° bis näherungsweise +85°, realisiert.

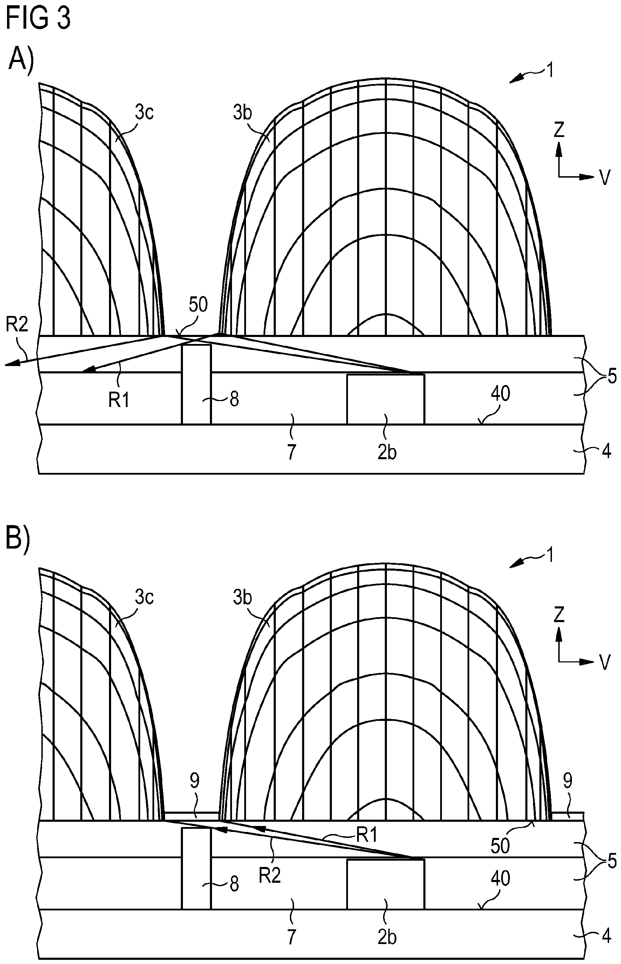

Beim Ausführungsbeispiel des Halbleiterbauteils 1 gemäß Figur 3 ist zwischen den benachbarten Linsenkörpern 3b, 3c eine Strahlfalle 8 angebracht. Die Strahlfalle 8 besteht beispielsweise aus einem Strahlung absorbierenden, lichtundurchlässigen Material. Die Strahlfalle 8 kann ein Teil des Trägers 4 sein oder als separate Komponente in den Verguss 5 eingebracht sein. Anders als in Figur 3A dargestellt, kann die Strahlfalle 8 optional bis zur Oberseite 50 des Vergusskörpers 5 reichen.

Strahlwege R1, R2 der vom Halbleiterchip 2b erzeugten Strahlung sind durch Pfeillinien symbolisiert. An der Oberseite 50 des Vergusskörpers 5 kann eine Totalreflexion erfolgen und die Strahlung, die vom Halbleiterchip 2b erzeugt ist, hierdurch zum benachbarten Linsenkörper 3c gelangen.

Gemäß Figur 3B ist an der Oberseite 50 des Vergusskörpers 5 in Bereichen, die nicht von den Linsenkörpern 3b, 3c bedeckt sind, eine Beschichtung 9 angebracht. Die Beschichtung 9 wirkt bevorzugt absorbierend bezüglich der vom Halbleiterchip 2b erzeugten Strahlung. Ist die Beschichtung 9 auf der Oberseite 50 aufgebracht, so kann optional die Strahlfalle 8 weggelassen werden.

Anders als in Figur 3B dargestellt können auch mehrere Beschichtungen 9 übereinander auf der Oberseite 50 des Vergusskörpers 5 aufgebracht sein. Eine dem Halbleiterchip 2b zugewandte erste Beschichtung ist beispielsweise absorbierend gestaltet und eine dem Halbleiterchip 2b abgewandte zweite Beschichtung an der Oberseite 50 kann farbig, weiß oder schwarz ausgeführt sein.

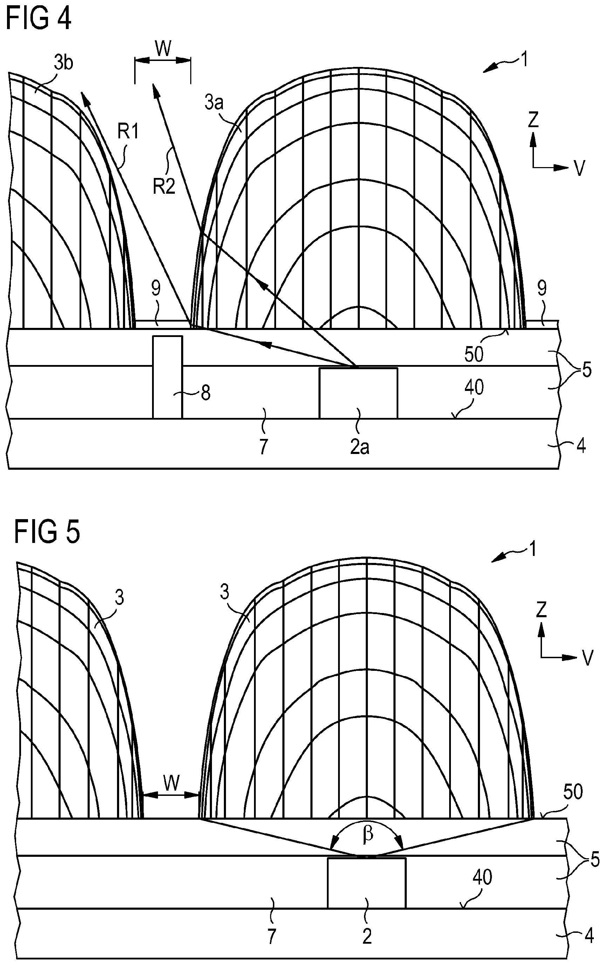

Gemäß Figur 4 weisen die benachbarten Linsenkörper 3 einen Abstand w zueinander auf, der beispielsweise mindestens 100 μm beträgt. Der Abstand w ist bevorzugt so groß gewählt, dass keine vom Halbleiterchip 2a erzeugte Strahlung, die zum zugeordneten Linsenkörper 3a gelangt, auf den benachbarten Linsenkörper 3b trifft. Somit wird keine oder fast keine der vom Halbleiterchip 2a erzeugten Strahlung durch den Linsenkörper 3b etwa durch Reflexion oder Refraktion beeinflusst.

Beim Beispiel gemäß Figur 5 weisen die Linsenkörper 3 entlang der vertikalen Richtung V einen Lichteinsammelwinkel β von zirka 150° auf. Ein Lichteinsammelwinkel entlang der horizontalen Richtung H liegt bevorzugt bei mindestens 160°. Hierdurch gelangt ein hoher Anteil der vom Halbleiterchip 2 emittierten Strahlungsleistung zu den Linsenkörpern 3, zum Beispiel mehr als 90 %. Somit wird fast die gesamte vom Halbleiterchip 2a emittierte Strahlung vom Linsenkörper 3a abgebildet beziehungsweise entsprechend der Gestaltung des Linsenkörpers 3a in ein Abstrahlprofil geformt.

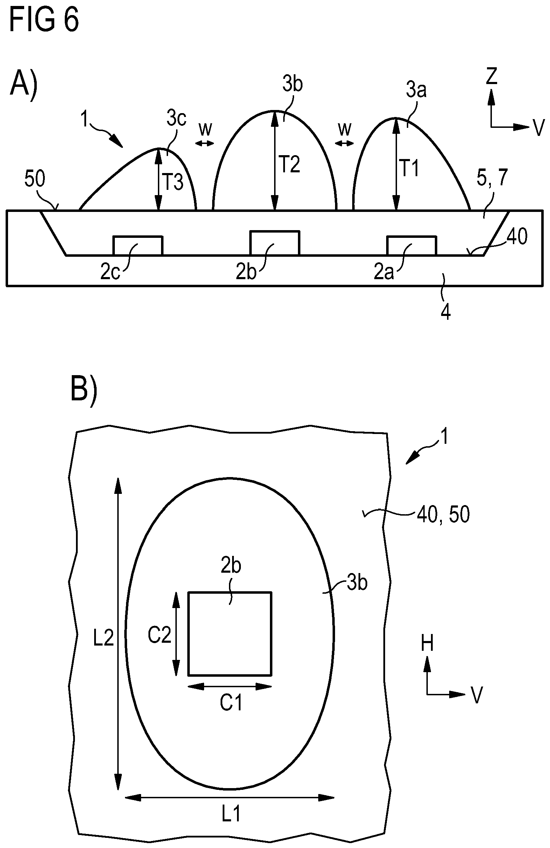

In Figur 6 ist ein Ausführungsbeispiel des optoelektronischen Bauteils 1 dargestellt, bei dem die drei Linsenkörper 3a-c jeweils verschieden voneinander geometrisch geformt sind, vergleiche die schematische Schnittdarstellung in Figur 6A und die Draufsicht in Figur 6B. Insbesondere weisen die drei Linsenkörper 3a-c unterschiedliche Höhen T1-3 entlang der Abstrahlrichtung z auf. Der Linsenkörper 3b weist zwei Symmetrieebenen auf, die durch die Abstrahlrichtung z und die vertikale Richtung V sowie durch die Abstrahlrichtung z und die horizontale Richtung H definiert sind. Die Linsenkörper 3a, 3c weisen jeweils nur eine einzige Symmetrieebene auf, die durch die vertikale Richtung V und die Abstrahlrichtung z definiert ist.

Die drei Halbleiterchips 2a-c weisen entlang der Abstrahlrichtung z jeweils unterschiedliche Höhen aus. Durch die ebenfalls unterschiedlichen Höhen T1-3 der Linsenkörper 3a-c kann dies ausgeglichen werden, so dass jede der von den Halbleiterchips 2a-c emittierten Strahlung in derselben oder in vergleichbarer Weise abgestrahlt wird.

Der Abstand w zwischen den benachbarten Linsenkörpern 3a-c beträgt beispielsweise mindestens 10 % der maximalen Ausdehnung L1 entlang der vertikalen Richtung V des Linsenkörpers 3b. Die Höhen T1-3 der jeweiligen Linsenkörper 3a-c liegen jeweils bevorzugt zwischen dem einschließlich 0,25-fachen und 0,95-fachen der zugehörigen maximalen Abmessung L2 des Linsenkörpers 3b entlang der horizontalen Richtung H. Ein Aspektverhältnis, definiert durch den Quotienten der maximalen Abmessungen L1, L2 liegt bevorzugt zwischen einschließlich 0,3 und 0,95. Weiterhin betragen die maximalen Ausdehnungen L1, L2 der Linsenkörper 3a-c insbesondere höchstens ein Sechsfaches der zugehörigen maximalen Abmessungen C1, C2 der Halbleiterchips 2a-c.

Die maximale Ausdehnung L2 entlang der horizontalen Richtung H liegt beispielsweise zwischen einschließlich 1 mm und 2 mm, die maximale Abmessung L1 des Linsenkörpers 3 entlang der vertikalen Richtung liegt beispielsweise zwischen einschließlich 0,5 mm und 1,5 mm. Die Höhe T2 ist bevorzugt kleiner oder gleich 1 mm. Laterale Abmessungen des gesamten Halbleiterbauteils 1 betragen beispielsweise zwischen 1,5 mm x 1,5 mm und 6 mm x 6 mm, insbesondere zirka 3 mm x 3 mm.

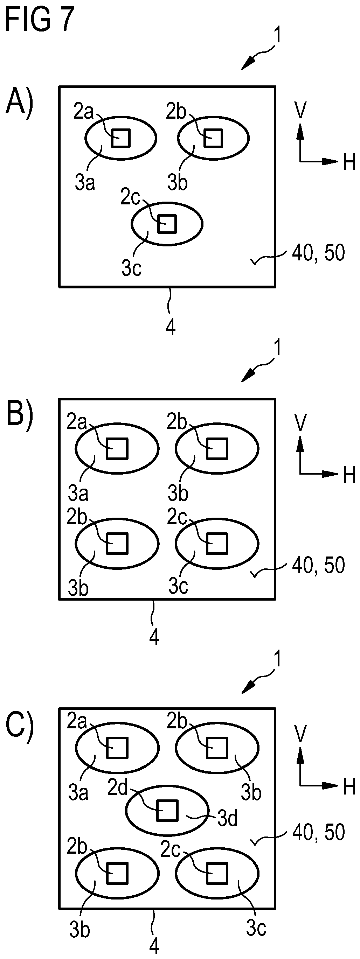

Gemäß den Figuren 7A, 7B und 7C sind die Linsenkörper 3a-c sowie die Halbleiterchips 2a-c in einer dreieckigen Anordnung beziehungsweise in einer quadratischen Anordnung, in Draufsicht auf den Träger 4 gesehen, angeordnet. Gemäß Figur 7B weist das Halbleiterbauteil 1 vier Halbleiterchips 2a-c sowie vier Linsenkörper 3a-c auf. Die Halbleiterchips 2b emittieren beispielsweise im grünen Spektralbereich, der Halbleiterchip 2a im roten und der Halbleiterchip 2c im blauen Spektralbereich. Das Halbleiterbauteil 1 gemäß Figur 7B ist also eine so genannte RGGB-Einheit. Gemäß Figur 7C ist zusätzlich ein Halbleiterchip 2d sowie ein Linsenkörper 3d im Flächenschwerpunkt des durch die Halbleiterchips 2a-c und durch die Linsenkörper 2a-c aufgespannten Vierecks angeordnet.

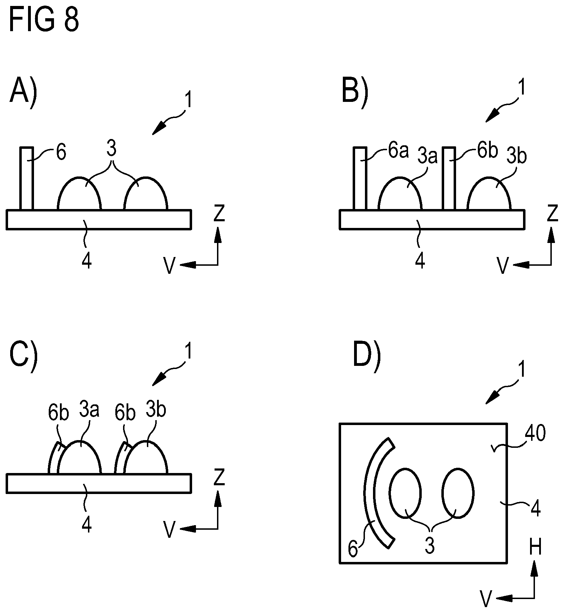

Bei den Beispielen gemäß Figur 8 umfassen die optoelektronischen Halbleiterbauteile 1 jeweils mindestens eine Abschirmung 6 gegen Fremdstrahlung. Die Fremdstrahlung ist beispielsweise durch direkte Sonneneinstrahlung gegeben.

Gemäß Figur 8A umfasst das Halbleiterbauteil 1 genau eine Abschirmung 6, die separiert von den Linsenkörpern 3 auf dem Träger 4 aufgebracht ist. Gemäß Figur 8B ist jedem der Linsenkörper 3a, 3b eine Abschirmung 6a, 6b zugeordnet. Beim Halbleiterbauteil 1 gemäß Figur 8C sind die Abschirmungen 6a, 6b an die Linsenkörper 3a, 3b angepasst oder angeformt. Ebenso ist es möglich, dass die Abschirmungen 6a, 6b von den Linsenkörpern 3a, 3b umfasst sind oder in diesen integriert sind. Gemäß der Draufsicht in Figur 8D weist die Abschirmung 6 einen länglichen, gekrümmten Grundriss auf.

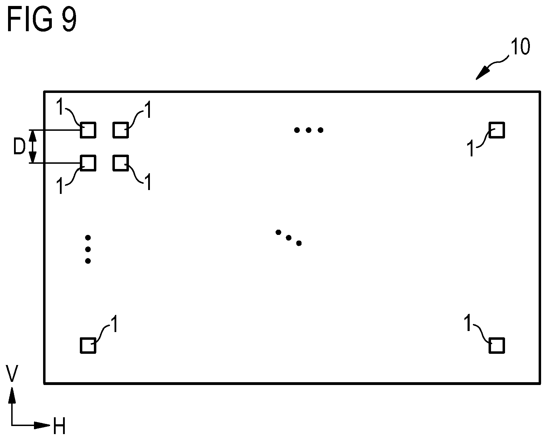

In Figur 9 ist ein Beispiel einer Anzeigeeinrichtung 10 dargestellt. Eine Vielzahl von optoelektronischen Halbleiterbauteilen 1, beispielsweise gestaltet gemäß einer der Figuren 1 und 3 bis 8, ist in einer matrixartigen zweidimensionalen Anordnung montiert. Durch die Halbleiterbauteile 1 sind Bildpunkte der Anzeigeeinrichtung 10 realisiert. Ein Abstand D zwischen benachbarten Bildpunkten und somit zwischen benachbarten Halbleiterbauteilen 1 beträgt beispielsweise zwischen einschließlich 12 mm und 23 mm. Insbesondere ist die Anzeigeeinrichtung 10 dazu eingerichtet, farbige Bilder und/oder Filme darzustellen.

Bei herkömmlichen Anzeigeeinrichtungen werden beispielsweise Halbleiterbauelemente verwendet, bei denen mehreren Chips auf einem gemeinsamen Montageträger eine einzige Linse nachgeordnet ist. Hierdurch werden von den Chips erzeugte, insbesondere verschiedenfarbige Strahlungen von der Linse unterschiedlich gebrochen, da sich die Chips beispielsweise bezogen auf einer optischen Achse der Linse an unterschiedlichen Positionen befinden. Bei einer solchen Anordnung, bei der mehrere Chips von einer einzigen Linse überdeckt sind, ist die erzielbare Farbhomogenität bezüglich eines Abstrahlwinkels begrenzt. Abhängig von einem Betrachtungswinkel kann hierdurch ein unterschiedlicher Farbeindruck entstehen.

Weiterhin können herkömmliche Anzeigeeinrichtungen Leuchtdioden aufweisen, denen keine oder nur eine radialsymmetrische Linse in Abstrahlrichtung nachgeordnet ist. Eine Abstrahlung erfolgt dann ebenfalls typisch rotationssymmetrisch in einem Lichtkegel mit einem Öffnungswinkel von zirka 120°. Für Anzeigeeinrichtungen ist dieser Abstrahlwinkel, speziell in der vertikalen Richtung, zu groß. Eine Strahlungsintensität in dem gewünschten Winkelbereich, beispielsweise 110° in der horizontalen Richtung und 40° in der vertikalen Richtung, ist hierdurch reduziert.

Weiterhin weisen herkömmliche Anzeigeeinrichtungen so genannte Radial-LEDs auf. Bei der Montage von Radial-LEDs treten vergleichsweise große Toleranzen bezüglich eines Winkels der Radial-LED zu einem Montageträger auf. Hierdurch kann eine Art Schielen, ein so genannter Dithering-Effekt, auftreten. Insbesondere für Videodisplays ist ein solcher Effekt unerwünscht.

**Patentansprüche**

1.  Optoelektronisches Halbleiterbauteil (1) mit

    - mindestens zwei optoelektronischen Halbleiterchips (2), die dazu eingerichtet sind, im Betrieb in voneinander verschiedenen Wellenlängenbereichen eine elektromagnetische Strahlung zu emittieren und die auf einer Montagefläche (40) eines gemeinsamen Trägers (4) angebracht sind,
    - mindestens zwei nicht rotationssymmetrisch gestalteten Linsenkörpern (3a-c), die dazu eingerichtet sind, entlang einer horizontalen Richtung (H) und einer vertikalen Richtung (V), die sowohl zueinander orthogonal als auch parallel zur Montagefläche (40) und senkrecht zu einer Hauptabstrahlrichtung (z) des Halbleiterbauteils (1) sind, die Strahlung in voneinander verschiedene Abstrahlwinkel ($\alpha$) zu formen,

wobei jedem der Halbleiterchips (2) einer der Linsenkörper (3) in einer Abstrahlrichtung (z) nachgeordnet ist, **dadurch gekennzeichnet, dass** die dem Träger abgewandte Begrenzungsfläche des Linsenkörpers von mindestens einem oder von allen Linsenkörpern (3), innerhalb einer Abweichung eines z-Wertes von höchstens 10 % einer maximalen Höhe (T) des jeweiligen Linsenkörpers (3), folgender Gleichung folgt:

$$z(x, y) = -0{,}33866\, x^2 - 0{,}93234\, y^2 - 0{,}54136\, x^4 - 1{,}25032\, x^2\, y^2 + 1{,}78606\, y^4 + 0{,}50057\, x^6 + 1{,}27170\, x^4\, y^2 + 0{,}06042\, x^2\, y^4 - 4{,}44960\, y^6 - 0{,}10344\, x^8 + 1{,}56205\, x^6\, y^2 + 6{,}38833\, x^4\, y^4 + 2{,}05268\, x^2\, y^6 - 18{,}7818\, y^8 - 0{,}158501\, x^{10} - 2{,}955774\, x^8\, y^2 - 10{,}73336\, x^6\, y^4 - 26{,}66134\, x^4\, y^6 - 2{,}344646\, x^2\, y^8 + 0{,}127770\, y^{10} \quad ,$$

mit x, y, z als einheitslose Zahlen, wobei eine x-Achse parallel zur horizontalen Richtung (H) und eine y-Achse parallel zur vertikalen Richtung (V) orientiert sind, wobei die x- und die y-Achse, bezogen auf den jeweiligen Linsenkörper, sich in der xy-Ebene schneiden, an der Stelle wo z für den jeweiligen Linsenkörper maximal ist.

2.  Optoelektronisches Halbleiterbauteil (1) nach dem vorhergehenden Anspruch,
    bei dem ein Farbort einer vom Halbleiterbauteil (1) emittierten Gesamtstrahlung sich in einem optischen Fernfeld, abhängig von einem Betrachtungswinkel, über einen Winkelbereich von mindestens 30° um höchstens 0,02 Einheiten der CIELUV-Normfarbtafel ändert.

3.  Optoelektronisches Halbleiterbauteil (1) nach dem vorhergehenden Anspruch,
    bei dem sich der Farbort der vom Halbleiterbauteil (1) emittierten Gesamtstrahlung, abhängig von dem Betrachtungswinkel, in der horizontalen Richtung (H) innerhalb eines Winkelbereichs von 110° und in der vertikalen Richtung (V) innerhalb eines Winkelbereichs von 40° um weniger als 0,04 Einheiten der CIELUV-Normfarbtafel ändert.

4.  Optoelektronisches Halbleiterbauteil (1) nach einem der vorhergehenden Ansprüche,
    bei dem ein Aspektverhältnis der Linsenkörper (3) bezüglich der zueinander orthogonalen Richtungen (H, V) zwischen einschließlich 0,3 und 0,9 liegt.

5.  Optoelektronisches Halbleiterbauteil (1) nach einem der vorhergehenden Ansprüche,
    bei dem maximale Ausdehnungen (L1, L2) der Linsenkörper (3) entlang der zueinander orthogonalen Richtungen (H, V) höchstens das Neunfache von maximalen Abmessungen (C1, C2) der Halbleiterchips (2) entlang der entsprechenden Richtungen (H, V) betragen.

6.  Optoelektronisches Halbleiterbauteil (1) nach einem der vorhergehenden Ansprüche,
    bei dem eine Höhe (T) der Linsenkörper (3) zwischen dem einschließlich 0,25-fachen und 0,95-fachen der maximalen Ausdehnung (L2) der Linsenkörper (3) entlang der zueinander orthogonalen Richtungen (H, V) liegt.

7.  Optoelektronisches Halbleiterbauteil (1) nach einem der vorhergehenden Ansprüche,
    bei dem benachbarte Linsenkörper (3) bezüglich der von den Halbleiterchips (2) emittierten Strahlung optisch voneinander isoliert sind.

8.  Optoelektronisches Halbleiterbauteil (1) nach einem der vorhergehenden Ansprüche,
    bei dem ein Lichteinsammelwinkel ($\beta$) der Linsenkörper (3) bezüglich der von dem zugeordneten Halbleiterchip (2) emittierten Strahlung entlang der horizontalen Richtung (H) mindestens 145° und entlang der vertikalen Richtung (V) mindestens 130° beträgt.

9.  Optoelektronisches Halbleiterbauteil (1) nach einem der vorhergehenden Ansprüche,
    bei dem die Linsenkörper (3) jeweils unterschiedlich ausgeformt sind.

**10.** Optoelektronisches Halbleiterbauteil (1) nach einem der vorhergehenden Ansprüche,
bei dem die Linsenkörper (3) in Draufsicht auf die Montagefläche (40) in einer dreieckigen Anordnung, in einer viereckigen Anordnung oder in einer viereckigen Anordnung, bei dem diese einen weiteren zentralen Linsenkörper (3) umfasst, vorliegen.

**11.** Optoelektronisches Halbleiterbauteil (1) nach einem der vorhergehenden Ansprüche,
bei dem sich zwischen den Linsenkörpern (3) und den Halbleiterchips (2) ein Vergusskörper (5) befindet, wobei sich, in Abstrahlrichtung gesehen, die Linsenkörper (3) auf dem Vergusskörper (5) befinden.

**12.** Optoelektronisches Halbleiterbauteil (1) nach einem der vorhergehenden Ansprüche,
bei dem alle Linsenkörper (3) oder bei dem alle Linsenkörper (3) und der Vergusskörper (5) einstückig gestaltet sind und aus demselben Material bestehen.

**13.** Optoelektronisches Halbleiterbauteil (1) nach einem der vorhergehenden Ansprüche,
das mindestens eine Abschirmung (6) gegen Fremdstrahlung umfasst.

**14.** Anzeigeeinrichtung (10) mit einer Vielzahl von Bildpunkten, bei der

- zumindest einer der Bildpunkte durch ein optoelektronisches Halbleiterbauteil (1) gemäß einem der vorhergehenden Ansprüche gebildet ist, und
- ein Abstand (D) zwischen benachbarten Bildpunkten zwischen einschließlich 4 mm und 75 mm beträgt.

**Claims**

**1.** An optoelectronic semiconductor component (1) comprising

- at least two optoelectronic semiconductor chips (2) which are configured to emit electromagnetic radiation in wavelength ranges different from each other and which are arranged on a mounting surface (40) of a common carrier (4),
- at least two non-rotationally symmetrical lens bodies (3a-c) which are designed, along a horizontal direction (H) and a vertical direction (V) which are arranged orthogonally to one another and parallel to the mounting surface (40) and perpendicular to a main emission direction (Z) of the semiconductor component (1), to shape the radiation into different emission angles ($\alpha$),

wherein each of the semiconductor chips (2) is followed by one of the lens bodies (3) along an emission direction (Z), **characterized in that**
the boundary surface of the lens body, which faces away from the carrier, of at least one or of all lens bodies (3) follows the following equation, within a deviation of a z value of at most 10% of a maximum height (T) of the respective lens body (3):
$z(x, y) = -0,33866\ x^2 - 0,93234\ y^2 - 0,54136\ x^4 - 1,25032\ x^2 y^2 + 1,78606\ y^4 + 0,50057\ x^6 + 1,27170\ x^4 y^2 + 0,06042\ x^2 y^4 - 4,44960\ y^6 - 0,10344\ x^8 + 1,56205\ x^6 y^2 + 6,38833\ x^4 y^4 + 2,05268\ x^2 y^6 - 18,7818\ y^8 - 0,158501\ x^{10} - 2,955774\ x^8 y^2 - 10,73336\ x^6 y^4 - 26,66134\ x^4 y^6 - 2,344646\ x^2 y^8 + 0,127770\ y^{10}$, with x, y, z as unit-free numbers, wherein an x-axis runs parallel to the horizontal direction (H) and a y-axis parallel to the vertical direction (V), wherein the x- and y-axis, relative to the respective lens body, intersect in the xy plane, at the point where z is maximal for the respective lens body.

**2.** The optoelectronic semiconductor component (1) according to the preceding claim,
in which a color locus of a total radiation emitted by the semiconductor component (1) in an optical far field, depending on a viewing angle over an angular range of at least 30°, changes by at most 0.02 units of the CIELUV standard chromaticity diagram.

**3.** The optoelectronic semiconductor component (1) according to the preceding claim,
in which the color locus of the total radiation emitted by the semiconductor component (1), depending on the viewing angle and in the horizontal direction (H) within an angular range of 110° and in the vertical direction (V) within an angular range of 40°, changes by less than 0.04 units of the CIELUV standard chromaticity diagram.

**4.** The optoelectronic semiconductor component (1) according to one of the preceding claims,

**EP 2 412 022 B1**

in which an aspect ratio of the lens bodies (3) with respect to the mutually orthogonal directions (H, V) is between 0.3 and 0.9 inclusive.

5. The optoelectronic semiconductor component (1) according to one of the preceding claims,
in which maximum extents (L1, L2) of the lens bodies (3) along the mutually orthogonal directions (H, V) are at most nine times maximum dimensions (C1, C2) of the semiconductor chips (2) along the corresponding directions (H, V).

6. The optoelectronic semiconductor component (1) according to one of the preceding claims,
in which a height (T) of the lens bodies (3) is between 0.25 times and 0.95 times the maximum extent (L2) of the lens body (3) along the mutually orthogonal directions (H, V).

7. The optoelectronic semiconductor component (1) according to one of the preceding claims,
in which adjacent lens bodies (3) are optically isolated from one another with respect to the radiation emitted by the semiconductor chips (2).

8. The optoelectronic semiconductor component (1) according to one of the preceding claims,
in which a light collecting angle (β) of the lens bodies (3) with respect to the radiation emitted by the associated semiconductor chip (2) is at least 145° along the horizontal direction (H) and is at least 130° along the vertical direction (V).

9. The optoelectronic semiconductor component (1) according to one of the preceding claims,
in which the lens bodies (3) are in each case formed differently.

10. The optoelectronic semiconductor component (1) according to one of the preceding claims,
in which, in a plan view of the mounting surface (40), the lens bodies (3) are arranged in a triangular arrangement, in a rectangular arrangement, or in a square arrangement in which the latter comprises a further central lens body (3).

11. The optoelectronic semiconductor component (1) according to one of the preceding claims,
in which a casting body (5) is arranged between the lens bodies (3) and the semiconductor chips (2),
wherein the lens bodies (3) are located on the casting body (5) when viewed in the direction of emission.

12. The optoelectronic semiconductor component (1) according to one of the preceding claims,
in which all lens bodies (3) or all the lens bodies (3) and the casting body (5) are configured in one piece and consist of the same material.

13. The optoelectronic semiconductor component (1) according to one of the preceding claims,
comprising at least one shield (6) against extraneous radiation.

14. A display device (10) comprising a plurality of pixels, in which

- at least one of the pixels is formed by an optoelectronic semiconductor component (1) according to one of the preceding claims, and
- a distance (D) between adjacent pixels is between 4 mm and 75 mm inclusive.

**Revendications**

1. Pièce semi-conductrice optoélectronique (1) dotée de

- au moins deux puces semi-conductrices optoélectroniques (2) qui sont destinées à émettre un rayonnement électromagnétique en marche dans des bandes de longueurs d'ondes différentes les unes des autres et qui sont montées sur une surface de montage (40) d'un support (4) commun,
- au moins deux corps de lentilles (3a-c) réalisés de manière non symétrique en rotation, qui sont destinés à former le rayonnement dans des angles de départ (α) différents les uns des autres, le long d'un axe horizontal (H) et d'un axe vertical (V) qui sont aussi bien orthogonaux l'un par rapport à l'autre que parallèles à la surface de montage (40) et perpendiculaires à une direction principale de départ (z) de la pièce semi-conductrice,

un des corps de lentilles (3) étant agencé, dans une direction de départ (z), après chacune des puces semi-conductrices (2),
**caractérisé en ce que**
la surface de délimitation, tournée dans le sens opposé au support, du corps de lentille d'au moins un ou de tous les corps de lentille (3) répondant à l'intérieur d'un écart d'une valeur z de 10 % maximum d'une hauteur (T) maximale du corps de lentille (3) respectif, à l'équation suivante :

$z (x, y) = - 0,33866\, x^2 - 0,93234\, y^2 - 0,54136\, x^4 - 1,25032\, x^2 y^2 + 1,78606\, y^4 + 0,50057\, x^6 + 1,27170\, x^4 y^2 + 0,06042\, x^2 y^4 - 4,44960\, y^6 - 0,10344\, x^8 + 1,56205\, x^6 y^2 + 6,38833\, x^4 y^4 + 2,05268\, x^2 y^6 - 18,7818\, y^8 - 0,158501\, x^{10} - 2,955774\, x^8 y^2 - 10,73336\, x^6 y^4 - 26,66134\, x^4 y^6 - 2,344646\, x^2 y^8 + 0,127770\, y^{10}$, où x, y, z sont des chiffres sans unité, un axe x étant orienté parallèlement à l'axe horizontal (H) et un axe y étant orienté parallèlement à l'axe vertical (V), les axes x et y convergeant dans le plan xy, en référence au corps de lentille respectif, là où z est à son maximum pour le corps de lentille respectif.

2. Pièce semi-conductrice optoélectronique (1) selon la revendication précédente, dans laquelle un lieu spectral d'un rayonnement total émis par la pièce semi-conductrice (1) change au maximum de 0,02 unités de l'espace chromatique CIELUV dans un champ lointain optique, suivant un angle de vue, sur une zone angulaire d'au moins 30°.

3. Pièce semi-conductrice optoélectronique (1) selon la revendication précédente, dans laquelle le lieu spectral du rayonnement total émis par la pièce semi-conductrice (1) change de moins de 0,04 unités de l'espace chromatique CIELUV, suivant l'angle de vue, dans l'axe horizontal (H) à l'intérieur d'une zone angulaire de 110° et dans l'axe vertical (V) à l'intérieur d'une zone angulaire de 40°.

4. Pièce semi-conductrice optoélectronique (1) selon l'une quelconque des revendications précédentes, dans laquelle un rapport d'aspect des corps de lentille (3) relatif aux axes (H, V) orthogonaux entre eux va de 0,3 inclus à 0,9.

5. Pièce semi-conductrice optoélectronique (1) selon l'une quelconque des revendications précédentes, dans laquelle des étirements (L1, L2) maximaux des corps de lentille (3) le long des axes (H, V) orthogonaux entre eux sont au maximum de 9 fois les dimensions maximales (C1, C2) des puces semi-conductrices (2) le long des axes (H, V) correspondants.

6. Pièce semi-conductrice optoélectronique (1) selon l'une quelconque des revendications précédentes, dans laquelle une hauteur (T) des corps de lentille (3) va de 0,25 fois inclus à 0,95 fois l'étirement maximal (L2) des corps de lentille (3) le long des axes (H, V) orthogonaux entre eux.

7. Pièce semi-conductrice optoélectronique (1) selon l'une quelconque des revendications précédentes, dans laquelle des corps de lentille (3) voisins sont isolés optiquement les uns des autres en ce qui concerne le rayonnement émis par les puces semi-conductrices (2).

8. Pièce semi-conductrice optoélectronique (1) selon l'une quelconque des revendications précédentes, dans laquelle un angle de collecte de la lumière (β) des corps de lentille (3) est, en ce qui concerne le rayonnement émis par la puce semi-conductrice (2) associée, d'au moins 145° le long de l'axe horizontal (H) et d'au moins 130° le long de l'axe vertical (V).

9. Pièce semi-conductrice optoélectronique (1) selon l'une quelconque des revendications précédentes, dans laquelle les corps de lentille (3) ont chacun une forme différente.

10. Pièce semi-conductrice optoélectronique (1) selon l'une quelconque des revendications précédentes, dans laquelle les corps de lentille (3) sont, dans une vue de dessus de la surface de montage (40), agencés en triangle, en quadrilatère ou en quadrilatère dans lequel celui-ci comprend un autre corps de lentille (3) central.

11. Pièce semi-conductrice optoélectronique (1) selon l'une quelconque des revendications précédentes, dans laquelle se trouve un corps moulé (5) entre les corps de lentille (3) et les puces semi-conductrices (2), les corps de lentille (3) se trouvant, vu dans la direction de départ, sur le corps moulé (5).

12. Pièce semi-conductrice optoélectronique (1) selon l'une quelconque des revendications précédentes, dans laquelle tous les corps de lentille (3) ou dans laquelle tous les corps de lentille (3) et le corps moulé (5) sont réalisés d'un seul tenant et constitués d'un seul et même matériau.

13. Pièce semi-conductrice optoélectronique (1) selon l'une quelconque des revendications précédentes qui comprend au moins un blindage (6) contre les rayonnements externes.

**14.** Dispositif d'affichage (10) doté d'une pluralité de points d'image, dans lequel

- au moins un des points d'image est formé par une pièce semi-conductrice optoélectronique (1) selon l'une quelconque des revendications précédentes, et
- une distance (D) entre les points d'image voisins va de 4 mm inclus à 75 mm.

FIG 1

FIG 2

A)

B)

FIG 3

A)

B)

FIG 4

FIG 5

FIG 6

A)

B)

## FIG 7

A)

2a 2b

3a 3b

2c

3c

40, 50

4

V
H

1

B)

2a 2b

3a 3b

2b 2c

3b 3c

40, 50

4

V
H

1

C)

2a 2b

3a 2d 3b

3d

2b 2c

3b 4 3c

40, 50

V
H

1

FIG 8

A)

B)

C)

D)

FIG 9

**IN DER BESCHREIBUNG AUFGEFÜHRTE DOKUMENTE**

**In der Beschreibung aufgeführte Patentdokumente**

- DE 102004057499 A1
- DE 102006047233 A1
- US 20070206390 A1
- EP 1641052 A2
- US 20070273984 A1
- US 6523976 B1